(19) Europäisches Patentamt

European Patent Office

Office européen des brevets

(11) EP 0 264 242 B1

(12) **EUROPEAN PATENT SPECIFICATION**

(45) Date of publication and mention
of the grant of the patent:
**08.01.1997 Bulletin 1997/02**

(51) Int Cl.$^6$: **H01L 29/78**, H01L 29/41,
H01L 29/10

(21) Application number: **87308978.3**

(22) Date of filing: **09.10.1987**

(54) **MOS semiconductor device**

MOS-Halbleiteranordnung

Dispositif à semi-conducteur MOS

(84) Designated Contracting States:
**DE FR GB**

(30) Priority: **09.10.1986 JP 240307/86**

(43) Date of publication of application:
**20.04.1988 Bulletin 1988/16**

(73) Proprietor: **KABUSHIKI KAISHA TOSHIBA**
**Kawasaki-shi, Kanagawa-ken 210 (JP)**

(72) Inventor: **Kakumu, Masakazu c/o Patent Division**
**1-1, Shibaura 1-Chome Minato-ku Tokyo (JP)**

(74) Representative: **Sturt, Clifford Mark et al**
**MARKS & CLERK**
**57-60 Lincoln's Inn Fields**
**London WC2A 3LS (GB)**

(56) References cited:
- IEEE TRANSACTIONS ELECTRON DEVICE, vol. ED-33, no. 1, January 1986, pages 140-144, IEEE, New York, US; H. MIKOSHIBA et al.: "Comparison of drain structures in n-Channel MOSFET's"
- IEEE TRANSACTIONS ON ELECTRON DEVICES, vol. ED-32, no. 3, March 1985, pages 562-570, IEEE, New York, US; M. KOYANAGI et al.: "Optimum design of n+-n- double-diffused drain MOSFET to reduce hot-carrier emission"
- EASCON '79 RECORD, IEEE ELECTRONICS AND AEROSPACE SYSTEMS CONVENTION, Arlington, VA, 25th-27th September 1978, vol. 2 of 3, pages 298-301, IEEE, New York, US; F.H. GAENSSLEN: "MOS device designs for future microelectronics - potentials and limitations"
- INTERNATIONAL ELECTRON DEVICES MEETING, TECHNICAL DIGEST, Washington, D.C., 1st-4th December 1985, pages 761-763, IEEE, New York, US; S. HORIGUCHI et al.: "Extremely high transconductance (above 500 mS/mm) MOSFET with 2.5 nm gate oxide"

## Description

This invention relates to an MOS semiconductor device. In particular, the invention relates to MOS semiconductor devices which are composed of submicron transistors.

At present, in an MOS-IC (MOS semiconductor integrated circuit) which includes MOS transistors, in order to achieve compatibility with TTL-ICS (transistor - transistor logic integrated circuits), the power source typically is set at 5 V, which is the same as that of the TTL-IC. The use of a 5 V power source voltage in an MOS-IC not only makes the MOS-IC compatible with the TTL-IC, but also increases the operating speed and improves the noise margin of the device.

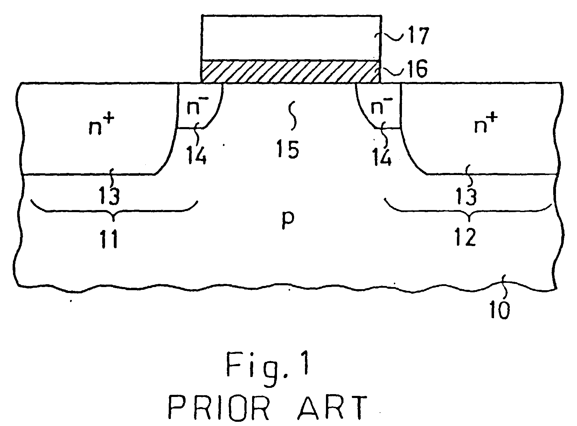

Nevertheless, when the gate-length of the MOS transistor used in an MOS-IC is shorter than 2 microns, reliability of the MOS transistor is reduced due to hot carriers. For this reasons, an MOS transistor, called an LDD (lightly doped drain) construction, was developed in the prior art, and this LDD transistor is currently in practical use. The element construction of this type of LDD MOS transistor is shown in cross-section in Figure 1. When using a p type substrate, for instance, as substrate 10, this transistor is constructed with source and drain regions 11 and 12. The regions 11 and 12 each have an n+ region 13 and an n⁻ region 14. Region 13 has an impurity distribution which is comparatively high, and region 14 has an impurity distribution which is comparatively low. A gate electrode 17 is provided on gate insulating film 16 above channel region 15 between the n⁻ regions 14 of source and drain regions 11 and 12.

In this type of LDD transistor, the electric field between channel region 15 and drain region 12 is relaxed by the existence of n⁻ region 14 with its comparatively low distribution. Thus, the generation of hot carriers by impact ionization is inhibited. For this reason, satisfactory reliability can be maintained in the case of transistors with gate-lengths down to 1 micron, even at power source voltages up to 5 V.

However, even in the case of LDD transistors, the problem of reliability once more arises when submicron gate-lengths of 1 micron or less are used. This is because the gate-length alone becomes shorter without reduction in the power source voltage. This causes the electric field in the MOS transistor to become extremely strong, and results in an increase in the amount of "hot carriers" in the device. These hot carriers tend to vary the threshold voltage, thereby reducing the reliability of the device. Consequently, in this case it is necessary to reduce the power source voltage.

In the prior art, the rule published by Dennard of IBM is well-known as a scaling rule between gate-length and power source voltage in this kind of submicron transistor. According to this rule, the internal electric field is kept constant by reducing the power source voltage in proportion to the gate-length. However, with this method, a problem arises in that an unnecessarily large degree of reduction of the power source voltage occurs, and the circuit performance is greatly reduced, when compared with that at 5 V.

In this way, when the gate-length of the MOS transistor in a MOS semiconductor device is shortened in accordance with the prior art scaling rule, the power source voltage becomes too low and the performance of the circuit is greatly reduced.

An object of the invention is to provide a MOS semiconductor device in which an increase in the speed of operation can be achived, an improvement of performance can be realised; and reliability is consistently high.

It is a further object of the invention to reduce the gate length of the gate electrodes in a semiconductor device without increasing the occurrence of hot carriers.

A first aspect of the present invention provides a MOS semiconductor device having an off state and an on state, comprising a submicron transistor, including a semiconductor substrate of a first conductive type, and capable of being operated by an applied power source voltage, comprising:

a gate insulation layer on the semiconductor substrate;
a gate electrode located on the gate insulation layer;
single type impurity regions of a second conductive type in the semiconductor substrate and adjacent to the gate electrode and the gate insulation layer, said impurity regions respectively defining a source and a drain across which said power-source voltage is applied; and
a channel region extending between said impurity regions, beneath said gate insulation layer (46);
wherein the maximum power supply voltage V which is applied to the drain during operation of the device is less than 5 volts and is determined by the gate length L in micrometers according to the equation

$$V1/1.1 \leq V \leq V1/0.9$$

where $V1 = 6.2 \times \sqrt{(L/2}$ in volts;
the gate insulation layer having an electric field in the range of 3 to 3.5 MV/cm applied thereto.
A second aspect of the present invention provides a MOS semiconductor device having an off state and an on state, comprising a submicron transistor, including a semiconductor substrate of a first conductive type, and capable of being operated by an applied power source voltage, comprising:

a gate insulation layer on the semiconductor substrate, the thickness of the gate insulation layer being a function of gate delay time and the impurity density of the substrate being a function of punch-through voltage;

a gate electrode on the gate insulation layer;
first impurity regions of a second conductive type in the semiconductor substrate and adjacent to the gate electrode and the gate insulation layer;
second impurity regions of a second conductive type, having a higher concentration than that of the first impurity regions, in the semiconductor substrate and adjacent to the first impurity regions, said second impurity regions respectively defining a source and a drain across which said power source voltage is applied; and
a channel region between said first impurity regions, beneath said gate insulation layer;
wherein the maximum power supply voltage V which is applied to the drain during operation of the device is less than 5 volts and is determined by the gate length l in micrometers according to the equation

$$V1/1.1 \leq V \leq V1/0.9$$

where V1 - 8.4 x $\sqrt{(L/2)}$ in volts;
the gate insulation layer has an electric field in the range of 3 to 3.5 MV/cm applied thereto.

IN the MOS semiconductor device of this invention, the power source voltage, which guarantees the reliability of the internal MOS transistor, and various parameters for improving the performance of the circuit are simultaneously checked and thus the device is designed to provide a solution which will satisfy both conditions.

The accompanying drawings illustrate an embodiment of the invention, and, together with the description, serve to explain the principles of the invention.

Figure 1 is a cross-sectional drawing showing an LDD transistor electronic device.

Figure 2 is a diagram of characteristics to illustrate this invention.

Figure 3 is a flowchart of a simulation to derive the characteristics in Figure 2.

Figure 4 is a cross-sectional drawing showing the various parameters used in the simulation of Figure 3.

Figures 5 and 6 are both characteristics diagrams to illustrate the parameters used in the simulation of Figure 3.

Figure 7 is a characteristic diagram of the characteristics derived from the simuation of Figure 3.

Figure 8 is a characteristic diagram of a circuit in which this invention is applied.

Figures 9 and 10 are both characteristics diagrams to illustrate this invention.

Reference will now be made in detail to the present preferred embodiment of the invention, an example of which is illustrated in the accompanying drawings.

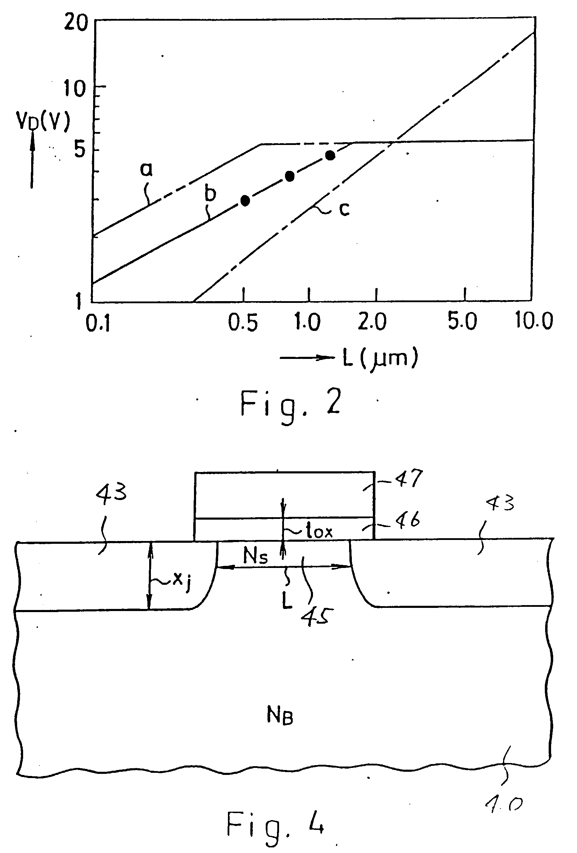

In the MOS semiconductor device of this invention, in the case of a MOS transistor of LDD construction in which the drain region is constructed of a high density region and a low density region, as shown in Figure 1, under the relationship shown in characteristic 'a' in the characteristics diagram in Figure 2, the value of drain voltage VD (power source voltage VDD) relative to gate-length L is set. In the case of a MOS transistor in which the drain region is constructed only of a single high-density region, under the relationship shown in characteristic 'b', the value of drain voltage VD (power source voltage VDD) to gate-length L is set. Characteristic 'c' in Figure 2 shows the relationship between gate-length L and drain voltage VD in the case of the prior art scaling rule according to Dennard.

Here, when VD is 5 V or less, the slope of characteristic 'a' becomes approximately 8.4 x $\sqrt{(L/2)}$ and the slope of characteristic 'b' becomes approximately 6.2 x $\sqrt{(L/2)}$

As is clear from Figure 2, each of the drain voltages VD shown by characteristics 'a' and 'b' can be set higher for the same gate-length than in the case of determination by the prior art scaling rule, which is shown by characteristic 'c'. Therefore, an increase in the speed of operation can be achieved, and improvement of performance can be realized. Moreover, as explained below, reliability is consistently high.

Next, the means of deriving the relationship between power source voltage and gate-length, such as that in Figure 2, is explained.

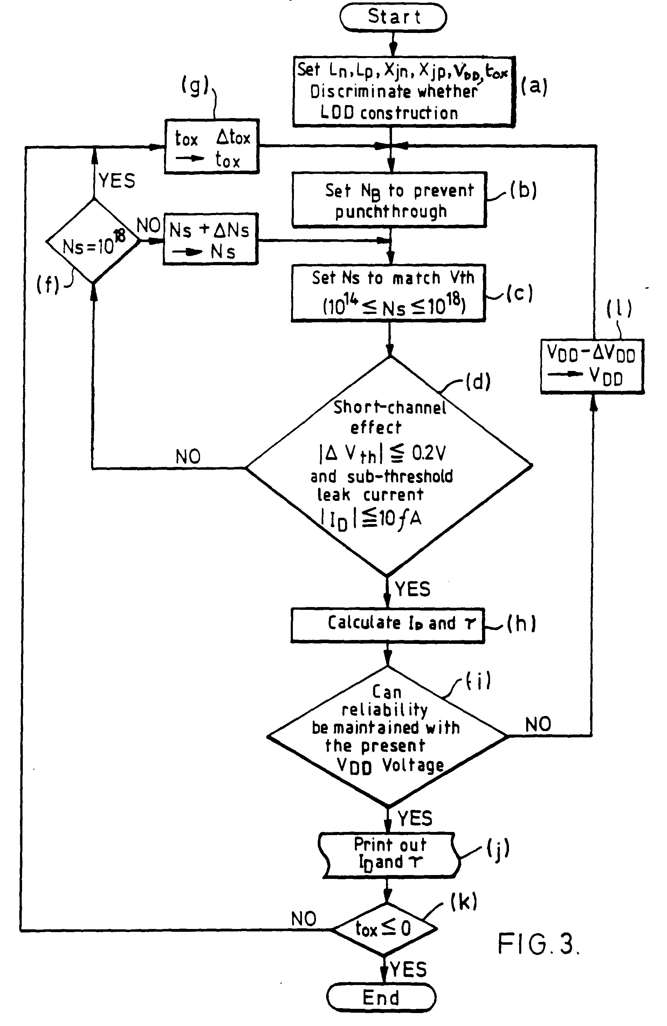

Figure 3 is a flowchart for a simulation to determine the relationship between the film thickness of a CMOS transistor gate insulating film and the gate delay time, and also the relationship between gate-length and the optimum power source voltage at that time.

First, in the initial Step (a), it is determined whether the MOS transistor is of LDD construction. The channel length Ln of an N-channel MOS transistor (hereafter, NMOSFET), the channel length Lp of a P-channel MOS transistor (hereafter, PMOSFET), the diffusion depth Xjn of the NMOSFET source and drain diffusion regions, the diffusion depth Xjp of the PMOSFET source and drain diffusion regions, and the initial value of the power source voltage VDD and the thickness tox of the gate insulating film and estabilshed. The values of Ln, Lp, Xjn, Xjp and tox are important parameters which determine the reliability of a MOS transistor.

Next, in Step (b), the impurity density NB of the substrate at which punch-through does not occur is established.

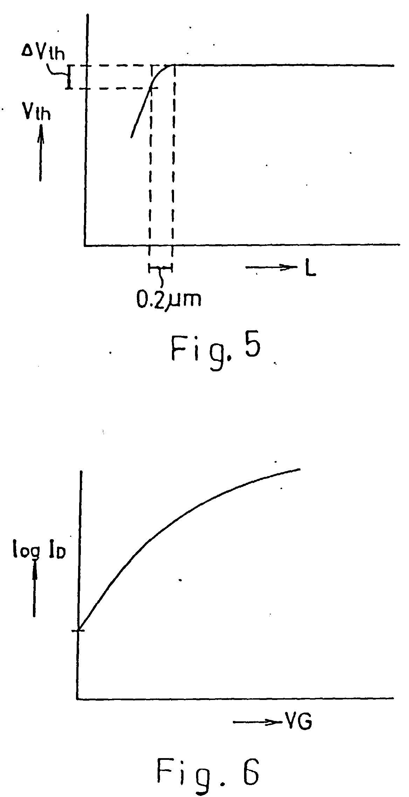

In Step (c), the impurity density Ns of the channel region surface to match a threshold voltage Vth is established. This value of Ns is set in the zone where it exceeds $10^{14}$ but does not exceed $10^{18}$. Also, L, tox, Xj, Ns and Nb are all shown in the cross-sectional drawing in Figure 4.

In Step (d), when the channel length is shorter than the previously set channel lengths Ln and Lp by 0.2 micron, it is determined wheter the short channel effect I Vth I is smaller than 0.2 V, and, at the same time, whether the value of the sub-threshold leak current is below 10 fA ($10^{-15}$A). The short channel effect, as shown in Figure 5, is the fluctuation component of the threshold voltage which occurs when channel length L becomes shorter by a certain unit length (in the example in Figure 5 this is 0. 2 micron). On the other hand, the sub-threshold leak current, as shown in Figure 6, is the value of the drain current ID which flows when the MOS transistor gate voltage VG is 0 V, that is to say, when no voltage is applied to the gate electrode.

At Step (d), if both conditions are not satisfied then, in the next Step (f), $10^{18}$ is compared with this new Ns. If there is agreement, a new tox is taken which is a specified $\Delta$ tox subtracted from the previous value of gate insulation film thickness tox. Then the simulation returns to Step (b).

On the other hand, if the new Ns is not $10^{18}$, the actual Ns is taken as $\Delta$Ns added to Ns and then the simulation returns to Step (c).

When it is judged in Step (d) that the specified conditions are satisfied, the drain current ID and the gate delay time $\tau$ are calculated in Step (h). It is possible to perform these calculations easily from the various values established in previous Steps.

In the next Step (i), first the value of the substrate current is calculated from the various values established in previous Steps. This substrate current is a parameter related to MOS transistor reliability. By the value of this substrate current, it is judged whether satisfactory reliability can be obtained at the present power source voltage VDD, when it is judged that satisfactory reliability can be obtained at this Step (i), the values of the drain current ID and the gate delay time $\tau$ are printed out in the next Step (j). After this, it is judged whether the gate insulation film tox is 0 at Step (k), and if not 0, the simulation returns to Step (g) and a similar operation is performed with a different gate insulation film tox. Then, when the gate insulation film tox is judged to be 0, the simulation ends at Step (k).

On the other hand, when it is judged in Step (i) that satisfactory reliability cannot be guaranteed by the then power source voltage VDD, a new VDD is taken in Step (i), which is specified $\Delta$VDD subtracted from the existing power source voltage VDD, and the simulation returns one more to Step (b).

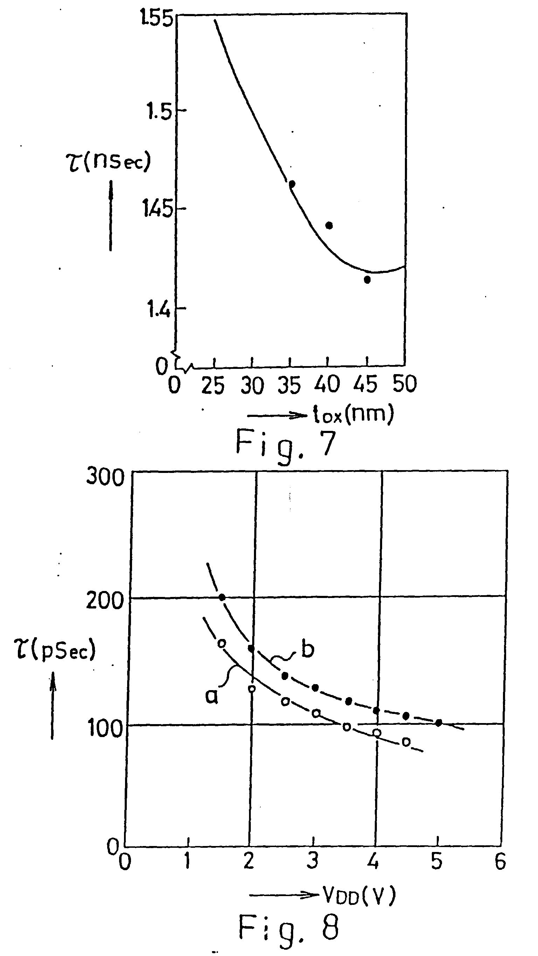

Figure 7 is a characteristic showing the relationship between the gate insulation film thickness tox (nm) and the gate delay time $\tau$ (nsec) obtained by the above simulation. As shown in the Figure, it can be seen that a parameter exists which has a delay time T with an extremely small value. Even though the example in Figure 7 is for a gate-length L of 2 microns and a power source voltage VDD 5 V, the highest speed operation is when tox is approximately 45 nm. In this way, the best parameters for circuit performance can be selected by the above simulation.

Figure 2 is the relationship obtained by this kind of simulation between the gate-length L in microns and the voltage VD in volts which will produce the highest speed operation when reliability is taken into account. In Figure 2, it can be seen that, in characteristic 'c', which is obtained by the prior art scaling rule, voltage VD is proportional to gate-length L. By contrast, in the case of characteristics 'a' and 'b' of this invention, both values of VD are approximately proportional to $\sqrt{L}$. Thus, when voltage VD is restricted to 5 V or less, the following relationship is established between VD and L in the case of characteristic 'a'

$$VD = 8.4 \times \sqrt{(L/2)} \qquad 1$$

At the same time, the following relationship is established between VD and L for characteristic 'b'

$$VD = 6.2 \times \sqrt{(L/2)} \qquad 2$$

Also, when voltage VD is given beforehand, Equations 1 and 2 can be rewritten as the following Equations 3 and 4.

$$L = 2(VD/8.4)^2 \qquad 3$$

$$L = 2(VD/6.2)^2 \qquad 4$$

In other words, it is most desirable from the points of performance and reliability to use the following minimum gate-lengths L which take into account the voltage margin (e.g. $\pm$ 10%) of a MOS transistor provided in an IC with a specified power source voltage VDD.

In the case of an LDD MOS transistor:

$$2((VD \pm 0.1VD)/8.4)^2.$$

In the case of an ordinary MOS transistor:

$$2((VD \pm 0.1VD)/6.2)^2.$$

Moreover, it is shown by the above simulation that the optimum gate oxide film thickness tox is when the electric field is set at 3 - 3.5 (MV/cm) ($10^6$V/cm).

Figure 8 shows the characteristics for the relationship between power source voltage VDD in volts and delay time τ in psec per gate in the case of the actual construction of a ring oscillator circuit using a 0.6 micron gate length MOS transistor in which the relationship between power source voltage and gate-length is specified in the above way, compared with a prior art example. Characteristic 'a' in the Figure is that of this invention, and the gate oxide film thickness tox is taken as 110 angstroms ($10^{-10}$m). Characteristic 'b' is that of prior art, and the gate oxide film thickness tox is taken as 130 angstroms ($10^{-10}$m). As is clear from the Figure, the operation speed per gate of this invention's device is faster than that of the prior art device. That is to say, the operation speeds in the case of a power source voltage of 3.5 V for this invention's device and in the case of power source voltage of 5 V for the prior art device are almost equal. With regard to reliability, needless to say, it is higher in the case of a power source voltage of 3.5 V.

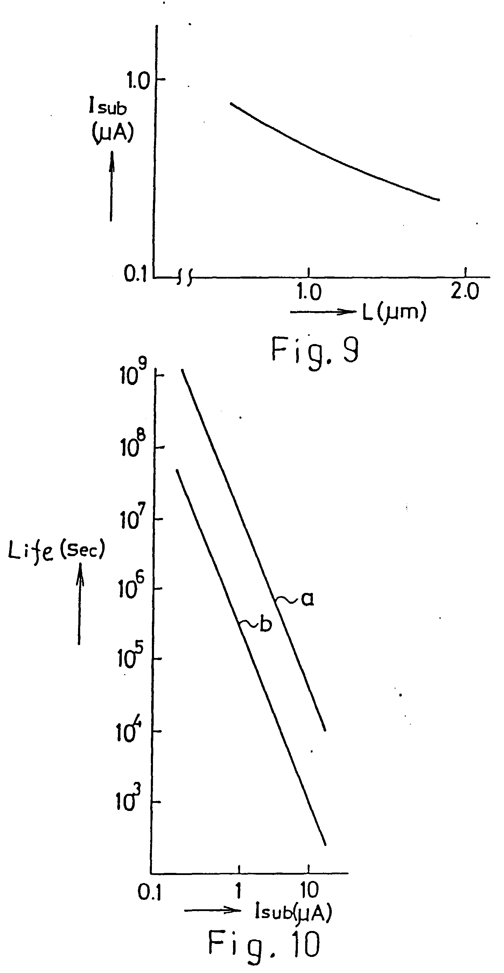

Figure 9 is a characteristic showing the relationship between gate-length L in microns and substrate current per unit area Isub in μA for a MOS transistor. Figure 10 shows characteristic relationships between substrate current per unit area Isub in μA and life-time of MOS transistors in seconds. Curve 'a' represents the case of 10% duty and curve 'b' is for 20% duty. As is clear from the curves in Figure 10, the life-time of a MOS transistor is determined by the value of the substrate current. On the other hand, the substrate current is determined by the functions of the drain voltage VD and the gate-length L. However, as shown in Figure 9, the dependency on the gate-length L is very small, while the dependency on the drain voltage VD is larger. This is because Isub is proportional to exp(-β/VD), where β is a constant value which depends on process and device parameter.

In this way, in the MOS semiconductor device of this invention, satisfactory performance can be obtained even if the power source voltage is reduced. Consequently, this invention can be applied not only for the above ring oscillator circuit, but also generally in MOS-IC's. Furthermore, in cases when MOS-IC's are constructed from interface circuits and internal circuits, this invention may be applied to integrated transistors in the interface circuits.

When using this invention as described above, a MOS semiconductor device can be provided which its reliability is consistently high without reducing circuit performance.

Various modifications and variations could be made to the invention without department from the scope of the invention.

**Claims**

1. A MOS semiconductor device, in operation, having an off state and an on state, comprising a submicron transistor, including a semiconductor substrate (40) of a first conductive type, and capable of being operated by an applied power source voltage, comprising:

   a gate insulation layer (46) on the semiconductor substrate (40),
   a gate electrode (47) located on the gate insulation layer (46);
   single type impurity regions (43) of a second conductive type in the semiconductor substrate (40) and adjacent to the gate electrode (47) and the gate insulation layer (46), said impurity regions (43) respectively defining a source and a drain across which said power-source voltage is applied; and
   a channel region (45) extending between said impurity regions (43), beneath said gate insulation layer (46);

   characterised in that the maximum power supply voltage V which is applied to the drain during operation of the device is less than 5 volts and is determined by the gate length L in micrometers according to the equation

   $$V1/1.1 \leq V \leq V1/0.9$$

   where $V1 = 6.2 \, x \, in \sqrt{(L/2)}$ volts;
   the gate insulation layer (46) having an electric field in the range of 3 to 3. 5 MV/cm applied thereto.

2. A MOS semiconductor device, in operation, having an off state and an on state, comprising a submicron transistor, including a semiconductor substrate (10) of a first conductive type, and capable of being operated by an applied power source voltage, comprising:

   a gate insulation layer (16) on the semiconductor substrate (10), the thickness of the gate insulation layer (16) being a function of gate delay time and the impurity density of the substrate (10) being a function of punch-through voltage;
   a gate electrode (17) on the gate insulation layer (16);
   first impurity regions (14) of a second conductive type in the semiconductor substrate (10) and adjacent to the gate electrode (17) and the gate insulation layer (16);
   second impurity regions (13) of a second conductive type, having a higher concentration than that of the first impurity regions (14), in the semiconductor substrate (10) and adjacent to the first impurity regions (14), said second impurity regions (13) respectively defining a source and a drain across which said power source voltage is applied; and
a channel region (15) between said first impurity regions (14), beneath said gate insulation layer (16);

characterised in that the maximum power supply voltage V which is applied to the drain during operation of the device is less than 5 volts and is determined by the gate length L in micrometers according to the equation

$$V1/1.1 \leq V < V1/0.9$$

where $V1 = 8.4 \times \sqrt{(L/2)}$ in volts;
the gate insulation layer has an electric field in the range of 3 to 3.5 MV/cm applied thereto.

## Patentansprüche

1. MOS-Halbleiteranordnung, die im Betrieb einen ausgeschalteten und einen eingeschalteten Zustand aufweist. mit einem Abmessungen unterhalb des Mikrometerbereichs aufweisenden Transistor. mit einem Halbleitersubstrat (40) eines ersten Leitungstyps und mit der Fähigkeit, durch eine angelegte Stromquellenspannung betrieben zu werden. mit:

einer Gate-Isolierschicht (46) auf dem Halbleitersubstrat (40).
einer Gate-Elektrode (47), die auf der Gate-Isolierschicht (46) angeordnet ist;
Einzelstörstellenbereichen (43) eines zweiten Leitungstyps im Halbleitersubstrat (40) und angrenzend an die Gate-Elektrode (47) und die Gate-Isolierschicht (46), wobei die Störstellenbereiche (43) jeweils eine Source und einen Drain bilden, über die die Stromquellenspannung angelegt wird; und
einem Kanalbereich (45), der sich zwischen den Störstellenbereichen (43) erstreckt, unter der Gate-Isolierschicht (46);

dadurch gekennzeichnet, daß die maximale Stromversorgungsspannung V, die während des Betriebs der Halbleiteranordnung an den Drain angelegt wird, kleiner als 5 Volt ist und durch die Gate-Länge L in Mikrometern nach der folgenden Gleichung bestimmt wird:

$$V1/1.1 \leq V \leq V1/0.9$$

wobei gilt: $V1 = 6{,}2 \times$ in $\sqrt{(L/2)}$ Volt;
wobei an die Gate-Isolierschicht (46) ein elektrisches Feld im Bereich von 3 bis 3,5 MV/cm angelegt wird.

2. MOS-Halbleiteranordnung, die im Betrieb einen ausgeschalteten und einen eingeschalteten Zustand aufweist. mit einem Abmessungen unterhalb des Mikrometerbereichs aufweisenden Transistor, mit einem Halbleitersubstrat (10) eines ersten Leitungstyps und mit der Fähigkeit, durch eine angelegte Stromquellenspannung betrieben zu werden, mit:

eine Gate-Isolierschicht (16) auf dem Halbleitersubstrat (10), wobei die Dicke der Gate-Isolierschicht (16) eine Funktion der Gate-Verzögerungszeit ist und die Störstellendichte des Substrats (10) eine Funktion der Durchschlagspannung ist;
einer Gate-Elektrode (17) auf der Gate-Isolierschicht (16);
ersten Störstellenbereichen (14) eines zweiten Leitungstyps im Halbleitersubstrat (10) und angrenzend an die Gate-Elektrode (17) und an die Gate-Isolierschicht (16);
zweiten Störstellenbereichen (13) eines zweiten Leitungstyps mit einer höheren Konzentration als die der ersten Störstellenbereiche (14) im Halbleitersubstrat (10) und angrenzend an die ersten Störstellenbereiche (14), wobei die zweiten Störstellenbereiche (13) jeweils eine Source und einen Drain bilden, über die die Stromquellenspannung angelegt wird; und
einem Kanalbereich (15) zwischen den ersten Störstellenbereichen (14), unter der Gate-Isolierschicht (16):

dadurch gekennzeichnet, daß die maximale Stromversorgungsspannung V, die während des Betriebs der Halbleiteranordnung an den Drain angelegt wird, kleiner ist als 5 Volt und durch die Gate-Länge L in Mikrometern nach der folgenden Gleichung bestimmt wird:

$$V1/1.1 \leq V \leq V1/0{,}9$$

wobei gilt $V1 = 8{,}4 \times$ in $\sqrt{(L/2)}$ Volt;
wobei an die Gate-Isolierschicht ein elektrisches Feld im Bereich von 3 bis 3.5 MV/cm angelegt wird.

## Revendications

1. Un dispositif à semiconducteurs MOS ayant, en fonctionnement, un état bloqué et un état conducteur, comprenant un transistor à échelle submicronique. comportant un substrat semiconducteur (40) d'un premier type de conductivité, et pouvant être alimenté par une tension de source d'alimentation appliquée. comprenant :

une couche d'isolation de grille (46) sur le substrat semiconducteur (40);

une électrode de grille (47) placée sur la couche d'isolation de grille (46);

des régions d'impuretés d'un seul type (43). ayant un second type de conductivité, formées dans le substrat semiconducteur (40) et adjacentes à l'électrode de grille (47) et à la couche d'isolation de grille (46), ces régions d'impuretés (43) définissant respectivement une source et un drain entre lesquels la tension de source d'alimentation est appliquée; et

une région de canal (45) s'étendant entre les régions d'impuretés (43), au-dessous de la couche d'isolation de grille (46);

caractérisé en ce que la tension d'alimentation maximale V qui est appliquée au drain pendant le fonctionnement du dispositif est inférieure à 5 volts et est déterminée par la longueur de grille L, en micromètres. conformément à la relation :

$$V1/1.1 \leq V \leq V1/0.9$$

avec $V1 = 6,2 \times \sqrt{(L/2)}$ , en volts; la couche d'isolation de grille (46) étant soumise à un champ électrique dans la plage de 3 à 3.5 MV/cm.

2. Un dispositif à semiconducteurs MOS ayant, en fonctionnement, un état bloqué et un état conducteur, comprenant un transistor à échelle submicronique, comportant un substrat semiconducteur (10) d'un premier type de conductivité, et pouvant être alimenté par une tension de source d'alimentation appliquée, comprenant :

une couche d'isolation de grille (16) sur le substrat semiconducteur (10), l'épaisseur de la couche d'isolation de grille (16) étant fonction du temps de retard de grille, et la densité d'impuretés du substrat (10) étant fonction de la tension de percement;

une électrode de grille (17) sur la couche d'isolation de grille (16);

des premières régions d'impuretés (14) d'un second type de conductivité, formées dans le substrat semiconducteur (10) et adjacentes à l'électrode de grille (17) et à la couche d'isolation de grille (16);

des secondes régions d'impuretés (13) d'un second type de conductivité, ayant une concentration supérieure à celle des premières régions d'impuretés (14), formées dans le substrat semiconducteur (10) et adjacentes aux premières régions d'impuretés (14). ces secondes régions d'impuretés (13) définissant respectivement une source et un drain entre lesquels une tension de source d'alimentation est appliquée; et

une région de canal (15) entre les premières régions d'impuretés (14), au-dessous de la couche d'isolation de grille (16);

caractérisé en ce que la tension d'alimentation maximale V qui est appliquée au drain pendant le fonctionnement du dispositif est inférieure à 5 volts et elle est déterminée par la longueur de grille L, en micromètres, conformément à l'équation :

$$V1/1,1 \leq V \leq V1/0,9$$

avec $V1 = 8,4 \times \sqrt{(L/2)}$ , en volts; la couche d'isolation de grille étant soumise à un champ électrique dans la plage de 3 à 3,5 MV/cm.

Fig.1
PRIOR ART

Fig. 2

Fig. 4

FIG.3.

Fig. 5

Fig. 6

Fig. 7

Fig. 8

Fig. 9

Fig. 10

13